# EUROPEAN PATENT APPLICATION

(11) **EP 4 668 586 A1**
(43) Date of publication of application: **24.12.2025**
(21) Application number: 24769640.4
(22) Date of filing: 12.01.2024
(51) Int. Cl.: H03M 7/30

(54) **DATA COMPRESSION METHOD AND APPARATUS**

(30) Priority: 10.03.2023 CN 202310232866; 05.05.2023 CN 202310498606
(71) Applicant: Huawei Cloud Computing Technologies Co., Ltd., Guiyang, Guizhou 550025 (CN)
(72) Inventor: WANG, Zhongyi, Guiyang, Guizhou 550025 (CN); BAI, Xiaolong, Guiyang, Guizhou 550025 (CN); LI, Shuqi, Guiyang, Guizhou 550025 (CN)
(74) Representative: Goddar, Heinz J.
(86) International application number: PCT/CN2024/072070
(87) International publication number: WO 2024/187944

(57) **Abstract**

This application discloses a data compression method and apparatus, and relates to the field of data processing technologies. The method includes: obtaining a first trace log generated in a running process of a first process, where each log record in the first trace log includes a function call record of calling a communication function by the first process; and constructing a first dictionary and a first grammar set based on the function call record in the first trace log, to compress the function call record in the first trace log, where for a first function call record included in any log record in the first trace log, a first symbol string in the first dictionary indicates the first function call record, and a first grammar tree in the first grammar set indicates a function call relationship in the first function call record. According to the method, a compression rate of compressing the trace log can be improved, and compression duration can be shortened.

## Description

This application claims priorities to Chinese Patent Application No. 202310232866.4, filed with the China National Intellectual Property Administration on March 10, 2023 and entitled "METHOD FOR COMPRESSING AND STORING MPI COMMUNICATION AND COMPUTING RECORD", and to Chinese Patent Application No. 202310498606.1, filed with the China National Intellectual Property Administration on May 5, 2023 and entitled "DATA COMPRESSION METHOD AND APPARATUS", both of which are incorporated herein by reference in their entireties.

### TECHNICAL FIELD

This application relates to the field of data processing technologies, and in particular, to a data compression method and apparatus.

### BACKGROUND

Data may be exchanged between a plurality of processes. For example, for a plurality of processes belonging to a same task, a large amount of data may be exchanged between the plurality of processes. Currently, data may be exchanged between a plurality of processes according to the message passing interface (message passing interface, MPI) protocol. In this case, a program executed by the process is a program that complies with the MPI protocol, which is briefly referred to as an MPI program.

When performance analysis is performed on the MPI program, performance analysis may be performed based on records of communication between the processes that execute the MPI program and hardware performance data of nodes that execute the MPI program. The record of communication between the processes may be usually obtained by generating a trace (trace) log. When a large amount of data is exchanged between the processes, a large quantity of trace logs are generated by the processes. Therefore, a server may compress the large quantity of trace logs generated when the process executes the MPI program, and store or transmit the compressed trace logs locally for analysis. In this way, local storage resources can be saved.

Therefore, how to improve a compression rate of compressing the trace log generated when the process executes the MPI program and reduce compression time becomes an urgent problem to be resolved.

### SUMMARY

This application provides a data compression method and apparatus. According to the method, a compression rate of compressing a trace log with a communication record can be improved, and compression time can be reduced.

To achieve the foregoing objective, this application provides the following technical solutions.

According to a first aspect, this application provides a data compression method. The method includes: obtaining a first trace log generated in a running process of a first process; and constructing a first dictionary and a first grammar set based on a function call record in the first trace log, to compress the function call record in the first trace log. The first trace log includes at least one log record, each log record in the first trace log includes a function call record of calling a communication function by the first process, and the communication function is a function for communication. The first dictionary includes at least one symbol string, and the first grammar set includes at least one grammar tree. For a first function call record included in any log record in the first trace log, a first symbol string in the first dictionary indicates the first function call record, and a first grammar tree in the first grammar set indicates a function call relationship in the first function call record.

Compared with a general compression method, in the method in this application, data features of the function call record in the trace log are considered. For example, in this application, the first dictionary indicating the function call record in the trace log is constructed, and the first grammar set indicating the function call relationship in the function call record is constructed, to compress the trace log. Therefore, compared with the general compression method in which the data feature of the trace log is not considered, the method provided in this application has a high compression rate and short compression time.

In a possible design, the communication function includes an MPI function.

According to the possible design, in a high-concurrency process scenario in which the MPI protocol is widely used currently, according to the method in this application, a trace log generated in the scenario can be compressed at a high compression rate.

In another possible design, the first dictionary further includes a first description information set, the first description information set includes at least one piece of description information, and the at least one piece of description information includes description information used to describe semantics of each symbol string in the first dictionary. When function call records in at least two log records in the first trace log have a same semantic structure, symbol strings that are in the first dictionary and that indicate the function call records in the at least two log records correspond to one piece of description information in the first description information set.

According to the possible design, in a process in which a same process calls communication functions, function call records in a plurality of generated log records have same or similar semantics. For example, these function call records include a same or similar type of parameter. Therefore, semantics of a plurality of symbol strings indicating the function call records in the plurality of log records may also be the same. In this way, the plurality of symbol strings that are in the first dictionary and that indicate the function call records that have the same semantic in the plurality of log records correspond to one piece of description information in the first description information set, so that the compression rate of the function call record in the trace log can be further improved.

In another possible design, when the first process is a process of a target application, the target application further includes a second process, and a second dictionary including a second description information set is obtained when a function call record in a second trace log generated in a running process of the second process is compressed. In this case, the method further includes: when it is determined that a quantity of pieces of different description information in the first description information set and the second description information set exceeds a threshold, compressing the first description information set and the second description information set based on a text similarity between the different description information in the first description information set and the second description information set.

When the target application includes a plurality of processes, according to the possible design, when trace logs generated by the plurality of processes are compressed, redundancy removal (or understood as deduplication) compression processing can be performed on a large quantity of different description information in dictionaries corresponding to the plurality of processes. This further improves a compression rate of compressing the trace logs generated by the plurality of processes.

In another possible design, the method further includes: when it is determined that the quantity of pieces of different description information in the first description information set and the second description information set is less than the threshold, combining the first description information set and the second description information set.

When the target application includes a plurality of processes, when trace logs generated by the plurality of processes are compressed, if there are a small quantity of pieces of different description information in dictionaries corresponding to the plurality of processes, according to the possible design, a simple combination operation can be directly performed on a plurality of description information sets of the plurality of processes. This can save, to some extent, compression duration for compressing the trace logs generated by the plurality of processes.

In another possible design, when the first process is a process of a target application, the target application further includes a second process, and a second grammar set is further obtained when a function call record in a second trace log generated in a running process of the second process is compressed. In this case, the method further includes: combining the first grammar set and the second grammar set based on function communication between the first process and the second process.

When the target application includes a plurality of processes, according to the possible design, a plurality of grammar sets corresponding to the plurality of processes can be combined, to further improve a compression rate of compressing trace logs generated by the plurality of processes.

In another possible design, each log record in the first trace log further includes time data, and the time data includes start time of calling the communication function and calling duration. The method further includes: compressing time data in the first trace log based on same calling duration in the first trace log.

According to the possible design, compared with a manner in which start and end time of calling a function are usually recorded in a log record, in this application, start and end time of calling the function are indicated by using the time at which the function starts to be called and the calling duration (namely, running duration of the function). Further, because running duration of communication functions is usually close or the same, the time data recorded in this application may have a large amount of repeated duration. In this case, a compression rate of compressing the time data is high.

In another possible design, when a hardware resource occupied by the first process in a node is a first hardware resource, the method further includes: obtaining a first dataset, where the first dataset includes performance data of the first hardware resource at a plurality of moments in the running process of the first process; and indicating, based on a preset value corresponding to each clustering range, data that is in the first dataset and that is within each clustering range, to obtain a second dataset obtained by compressing the first dataset. A data difference in each clustering range is less than or equal to a preset error, and different clustering ranges correspond to different preset values.

According to the possible design, for the performance data of the hardware resource occupied by the process in the running process, namely, the first dataset, when the preset value corresponding to each clustering range indicates the data in the first dataset, there are a large quantity of same characters in the first dataset, and in this case, a compression rate of compressing the first dataset is high.

In another possible design, the performance data includes at least one of the following: instructions per cycle (instructions per cycle, IPC), a cache miss rate (cache miss rate, CMR), a cache hit rate (cache hit rate, CHR), and a branch misprediction rate (branch misprediction rate, BMR).

In another possible design, when the first process is a process of a target application, the target application further includes a second process, a hardware resource occupied by the second process in a node is a second hardware resource, a third dataset includes performance data of the second hardware resource at a plurality of moments in a running process of the second process, and a fourth dataset is obtained by compressing the third dataset based on the preset value corresponding to each clustering range. The method further includes: indicating, based on the preset value corresponding to each clustering range, data that is in the second dataset and the fourth dataset and that is within each clustering range, to compress the second dataset and the fourth dataset.

According to the possible design, performance data of hardware resources respectively occupied by a plurality of processes in running processes can be further compressed. This further improves a compression rate of compressing the performance data of the hardware resources respectively occupied by the plurality of processes in the running processes.

In another possible design, the first process and the second process run on different nodes.

According to the possible design, the method in this application is applicable to a scenario in which a plurality of processes run in a cluster.

According to a second aspect, this application provides a data compression apparatus.

In a possible design, the data compression apparatus is configured to perform any method according to the first aspect. In this application, the data compression apparatus may be divided into functional modules according to any method provided in the first aspect. For example, each functional module may be obtained through division based on each corresponding function, or two or more functions may be integrated into one processing module. For example, in this application, the data compression apparatus may be divided into an obtaining unit, a processing unit, and the like based on functions. For descriptions of possible technical solutions performed by the functional modules obtained through division and beneficial effect, refer to the technical solutions provided in the first aspect or the corresponding possible designs of the first aspect. Details are not described herein again.

In another possible design, the data compression apparatus includes a memory, a communication interface, and one or more processors. The one or more processors receive or send data through the communication interface, and the one or more processors are configured to read program instructions stored in the memory, to perform any method according to the first aspect and any possible design of the first aspect.

According to a third aspect, this application provides a computer-readable storage medium. The computer-readable storage medium includes program instructions, and when the program instructions are run on a computer or a processor, the computer or the processor is enabled to perform any method according to any possible implementation of the first aspect.

According to a fourth aspect, this application provides a computer program product. When the computer program product runs on a data compression apparatus, any method according to any possible implementation of the first aspect is performed.

According to a fifth aspect, this application provides a chip system, including a processor. The processor is configured to invoke, from a memory, a computer program stored in the memory and run the computer program, to perform any method according to the implementation of the first aspect.

It may be understood that any one of the apparatus, the computer storage medium, the computer program product, the chip system, or the like provided above may be used in the corresponding method provided above. Therefore, for beneficial effect that can be achieved by any one of the apparatus, the computer storage medium, the computer program product, the chip system, or the like, refer to the beneficial effect of the corresponding method. Details are not described herein.

In this application, a name of the data compression apparatus does not constitute a limitation on devices or functional modules. In actual implementation, these devices or functional modules may have other names. Each device or functional module falls within the scope defined by the claims and their equivalent technologies in this application, provided that a function of the device or functional module is similar to that described in this application.

### BRIEF DESCRIPTION OF DRAWINGS

FIG. 1 is a diagram of an application scenario of a data compression method according to an embodiment of this application;
FIG. 2 is a diagram of a scenario in which a target application runs on a single node according to an embodiment of this application;
FIG. 3 is a diagram of a scenario in which a target application runs on a plurality of nodes according to an embodiment of this application;
FIG. 4 is a diagram of a hardware structure of a computing node according to an embodiment of this application;
FIG. 5 is a schematic flowchart of a data compression method according to an embodiment of this application;
FIG. 6 is a block diagram of a process of constructing a first dictionary corresponding to a first trace log according to an embodiment of this application;
FIG. 7 is a schematic flowchart of another data compression method according to an embodiment of this application;
FIG. 8 is a block diagram of a process of compressing a first dataset according to an embodiment of this application;
FIG. 9 is a schematic flowchart of still another data compression method according to an embodiment of this application;
FIG. 10 is a schematic flowchart of yet another data compression method according to an embodiment of this application;
FIG. 11 is a diagram of a compression result obtained by performing data compression by using a method according to this application;
FIG. 12 is a diagram of comparison results of compression rates of compressing data by using a method according to this application and other compression methods;
FIG. 13 is a diagram of comparison results of compression time for compressing data by using a method according to this application and other compression methods;
FIG. 14 is a diagram of a structure of a data compression apparatus according to an embodiment of this application; and
FIG. 15 is a diagram of a structure of a chip system according to an embodiment of this application.

### DESCRIPTION OF EMBODIMENTS

To understand embodiments of this application more clearly, the following describes some terms or technologies used in embodiments of this application.

### (1) Communication function

In embodiments of this application, functions that communicate with each other are referred to as communication functions. Alternatively, the communication function is understood as a function for communication. The communication function may be a function for mutual communication inside a process. Alternatively, the communication function may be a function for mutual communication between processes, and is not limited thereto.

When the communication function is the function for mutual communication between processes, the function for mutual communication between processes actually implements communication between the processes. For example, in running processes of a process 1 and a process 2, the process 1 calls a function 1, and the process 2 calls a function 2. When the function 1 communicates with the function 2, both the function 1 and the function 2 may be referred to as communication functions, and communication between the function 1 and the function 2 actually implements communication between the process 1 and the process 2.

In some examples, the communication function may be a function that supports a message passing interface (message passing interface, MPI) protocol.

### (2) Trace (trace) log

In embodiments of this application, the trace log is used to record a communication record in a running process of a process. A trace log generated by a single process may include one or more log records, and one log record may be used to record a function call record when the process calls a communication function.

It should be understood that, when a function is called, a parameter of the function needs to be transferred. Therefore, in some examples, a function call record in one log record may include a process identifier (identifier, ID), a function name, a function parameter, a start timestamp, and an end timestamp.

A process identified by the process ID is a process that generates the current log record.

The function name is a function name of a communication function called by the process. Herein, the communication function called by the process may be a function that communicates with another function in the process, or may be a function that communicates with a process other than the process. This is not limited.

The function parameter is a parameter of the communication function called by the process. The function parameter usually includes a plurality of parameter items. One parameter item indicates one type of parameter, and one parameter item includes a parameter name and a parameter value of a parameter indicated by the parameter item.

The start timestamp indicates time at which the process starts to call the communication function. The end timestamp indicates time at which the process ends scheduling the communication function, or is understood as time at which the process completes execution of the currently called communication function.

For example, it is assumed that a process (or referred to as a process 0) whose process ID is 0 calls, in a running process, a communication function for communicating with another function, and a function name of the communication function is MPI_Isend. Therefore, in a process of calling the communication function MPI_Isend, the process 0 may generate a log record 0 by using a trace collection tool:

```
         Rank=0 Function:MPI_Isend
         Paravalues:=(
           mpip_const_void_t buf=-1270915064,
           int count=961,
           MPI_Datatype datatype=1275070475,
           Int dest=4,
           Int tag=1024,
           MPI_Comm comm=1140850688,
           MPI _Request request=160750800)
         Starttime=[1554884741014733]
         Endtime=[1554884741014789]
```

"Rank=0" indicates the process 0. "Function:MPI_Isend" indicates the communication function called by the process 0, and the function name of the communication function is "MPI_Isend". "Paravalues:=( )" indicates parameters of the communication function MPI_Isend, each row in the bracket indicates one parameter item that indicates one type of parameter, and one reference item includes a parameter name before the equal sign and a parameter value after the equal sign. "Starttime" is time at which the process 0 starts to call the communication function MPI_Isend, and "Endtime" is time at which the process 0 ends calling the communication function MPI_Isend.

In some other examples, in addition to the process identifier, the function name, the function parameter, the start timestamp, and the end timestamp, a function call record in one log record further includes, in the communication function (namely, the communication function indicated by the function name) called by the process that generates the current log record, a record in which another communication function is included or called.

### (3) Other terms

In embodiments of this application, terms "first" and "second" do not indicate a sequence relationship, but are intended to distinguish between different objects. "First", "second", and the like mentioned in the following documents are also intended to distinguish between different packets and the like, and should not be understood as an indication or an implication of relative importance or an implication of a quantity of indicated technical features.

It should be understood that sequence numbers of processes do not mean execution sequences in embodiments of this application. The execution sequences of the processes shall be determined based on functions and internal logic of the processes, and should not constitute any limitation on implementation processes of embodiments of this application.

It should be further understood that a term "at least one" "in embodiments of this application means one or more. In embodiments of this application, a term "a plurality of" means two or more.

The trace log generated in the running process of the process can be compressed by using a general compression technology (for example, the Zlib compression technology). However, when the general compression technology is used to compress the trace log, a compression rate is low, and compression time is long.

In view of this, embodiments of this application provide a data compression method. For a trace log generated in a running process of a process, in the method, different data in the trace log is compressed in different processing manners. For example, for a function call record of calling a communication function in a trace log, in the method, the calling record in the trace log is compressed by constructing a dictionary and a grammar set that correspond to the function call record. For another example, for time data of calling the communication function in the trace log, in the method, time at which the communication function starts to be called and calling duration are used as the time data of calling the communication function in the trace log, and the time data of calling the communication function in the trace log is compressed based on repeated calling duration in the time data.

Therefore, different data in the trace log is compressed in different processing manners, so that a compression rate of compressing the trace log can be greatly improved, and compression duration can be shortened.

The process may be a process used to run any application (or computing task). For example, the process is a process used to run a target application. A type of the target application, a function implemented by the target application, and the like are not specifically limited in embodiments of this application.

Optionally, the target application may be a simulation application, a neural network model with a classification function, or the like. This is not limited thereto. In an example, the target application may be an application that implements a conjugate gradient method. The conjugate gradient method is a common iteration method, and is used to solve a large system of linear equations.

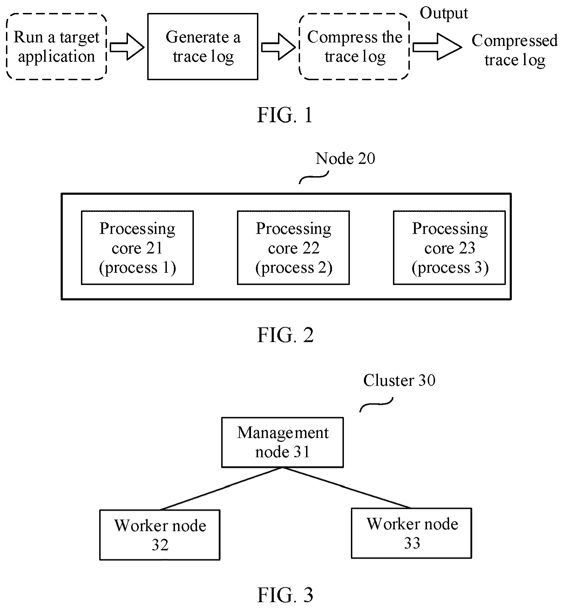

FIG. 1 is a diagram of an application scenario of a data compression method according to an embodiment of this application. As shown in FIG. 1, in a process in which a node runs a target application, a process of the target application may generate a trace log. Then, the node compresses the trace log and outputs the compressed trace log. In this way, when performance analysis needs to be performed on the program of the target application, an analysis device may obtain the compressed trace log. Therefore, the compressed trace log can save transmission resources between the node that generates original data of the trace log and the analysis device, and save storage space that is in the analysis device and that is used to store the trace log.

The method provided in embodiments of this application is used to implement the trace log compression part in the scenario shown in FIG. 1.

Optionally, the target application may be executed by using one or more processes, or it is understood that the target application may include one or more processes. It may be understood that, when the target application is executed in parallel by using a plurality of processes, processing efficiency of the target application can be improved.

Optionally, when the target application is executed by using a plurality of processes, the plurality of processes may run in parallel on a single node, or run in parallel on a cluster including a plurality of nodes. This is not limited.

The following shows two running scenarios of the target application as examples. It is assumed that the target application includes three processes, which are respectively a process 1, a process 2, and a process 3. The process 1 is a main process of the target application, and the process 2 and the process 3 are child processes of the target application. The main process of the target application is used as an entry for executing the target application, and is configured to control and connect the child processes.

FIG. 2 is a diagram of a scenario in which the target application runs on a single node according to an embodiment of this application. As shown in FIG. 2, the node 20 includes a processing core 21, a processing core 22, and a processing core 23. In this way, the process 1 may run in the processing core 21, the process 2 may run in the processing core 22, and the process 3 may run in the processing core 23. It should be understood that the node 20 may further include more processing cores. This is not limited.

FIG. 3 is a diagram of a scenario in which the target application runs on a plurality of nodes according to an embodiment of this application. As shown in FIG. 3, the cluster 30 includes a management node 31, a worker node 32, and a worker node 33. Certainly, the cluster 30 may further include more worker nodes (not shown in FIG. 3). The management node 31 is configured to: manage and control each worker node in the cluster 30. In this case, the process 1 may run on the management node 31, the process 2 may run on the worker node 32, and the process 3 may run on the worker node 33.

Optionally, a function of the management node in the cluster 30 may alternatively be undertaken by a worker node in the cluster 30. In this case, the process 1 may run on the worker node with the function of the management node.

Embodiments of this application further provide a data compression apparatus. The compression apparatus is configured to perform the data compression method provided in embodiments of this application. Optionally, the compression apparatus may be any computing node having computing and processing capabilities, or a functional module in the computing node. The computing node can access the trace log generated in the running process of the process of the target application.

It should be understood that, in the running process of the process of the target application, the generated trace log is written into storage space corresponding to a preset file directory. The storage space corresponding to the preset file directory may be local storage space of the node that runs the target application, or storage space that is of a storage system and that can be accessed by the node that runs the target application. This is not limited. Optionally, when the storage space corresponding to the preset file directory is the local storage space of the node that runs the target application, the local storage space may be local storage space of a node that runs the main process of the target application. The preset file directory corresponding to the trace log may also be referred to as a default file directory of the trace log.

In an example, the computing node is a node on which the target application runs. Optionally, when the target application runs in the cluster, the computing node may be a management node on which the main process of the target application runs. This is not limited.

In another example, the computing node includes but is not limited to a computing device like a general-purpose computer, a notebook computer, or a tablet computer. Alternatively, the computing node is a server.

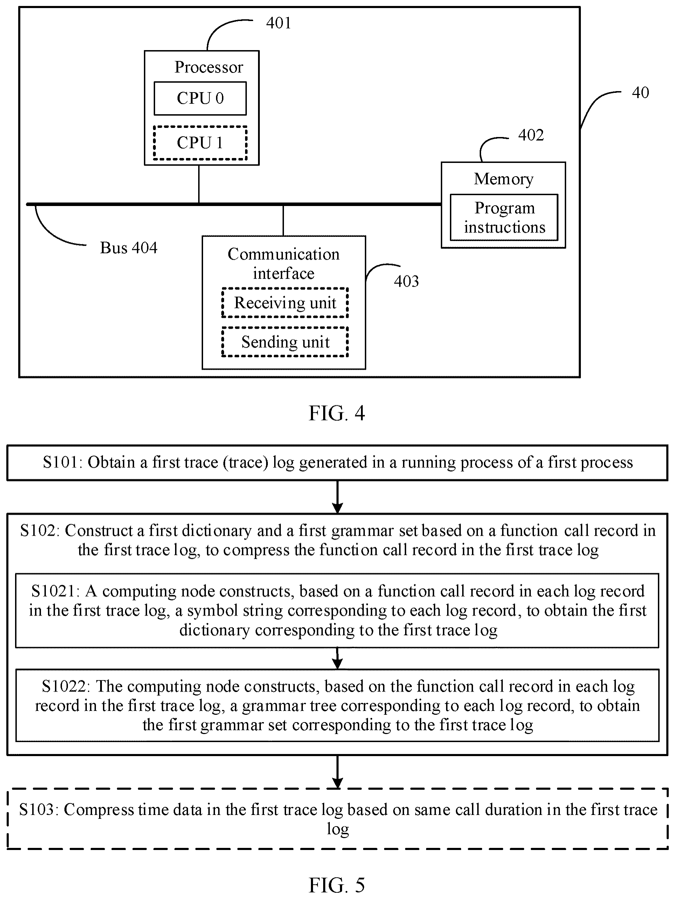

FIG. 4 is a diagram of a hardware structure of a computing node according to an embodiment of this application. As shown in FIG. 4, the computing node 40 includes a processor 401, a memory 402, a communication interface 403, and a bus 404. The processor 401, the memory 402, and the communication interface 403 are connected to each other through the bus 404.

The processor 401 is a control center of the computing node 40, and may be a general-purpose central processing unit (central processing unit, CPU), or the processor 401 may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, a discrete hardware component, a graphics processing unit (graphics processing unit, GPU), a neural-network processing unit (neural-network processing unit, NPU), a tensor processing unit (tensor processing unit, TPU) or an artificial intelligence (artificial intelligence) chip, a data processing unit (data processing unit, DPU), or the like.

In an example, the processor 401 includes one or more CPUs, for example, a CPU 0 and a CPU 1 shown in FIG. 4. In addition, a quantity of processor cores in each processor is not limited in this application.

The memory 402 is configured to store program instructions or data to be accessed by an application process. The processor 401 may execute the program instructions in the memory 402, to implement the data compression method provided in embodiments of this application.

The memory 402 may include a volatile memory or a non-volatile memory, or may include both a volatile memory and a non-volatile memory. The volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and is used as an external cache. Through example but not limitative descriptions, many forms of RAMs may be used, for example, a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM). The non-volatile memory may be a storage class memory (storage class memory, SCM), a solid-state drive (solid-state drive, SSD), a hard disk drive (hard disk drive, HDD), or the like. The storage class memory may be, for example, a non-volatile memory (non-volatile memory, NVM), a phase-change memory (phase-change memory, PCM), or a persistent memory.

In a possible implementation, the memory 402 is independent of the processor 401. The memory 402 is connected to the processor 401 through the bus 404, and is configured to store data, instructions, or program code. When calling and executing the instructions or program code stored in the memory 402, the processor 401 can implement the data compression method provided in embodiments of this application.

In another possible implementation, the memory 402 and the processor 401 are integrated together.

The communication interface 403 is used by the computing node 40 to connect to another device (for example, an analysis device that needs to obtain a trace log) over a communication network. The communication network may be the Ethernet, a radio access network (radio access network, RAN), a wireless local area network (wireless local area network, WLAN), or the like. The communication interface 403 includes a receiving unit configured to receive data and a sending unit configured to send data.

The bus 404 may be an industry standard architecture (industry standard architecture, ISA) bus, a peripheral component interconnect (peripheral component interconnect, PCI) bus, a high-speed serial computer extended bus (peripheral component interconnect express, PCIe), a compute express link (compute express link, CXL), an extended industry standard architecture (extended industry standard architecture, EISA) bus, or the like. The bus may be classified into an address bus, a data bus, a control bus, and the like. For ease of indication, the bus is indicated by only one thick line in FIG. 4, but this does not indicate that there is only one bus or one type of bus.

It should be noted that the structure shown in FIG. 4 does not constitute a limitation on the computing node 40. In addition to the components shown in FIG. 4, the computing node 40 may include more or fewer components than those shown in FIG. 4, a combination of some components, or a different component layout.

The following describes the data compression method provided in embodiments of this application with reference to accompanying drawings.

In some embodiments, FIG. 5 is a schematic flowchart of a data compression method according to an embodiment of this application. Optionally, the method may be performed by a computing node having the hardware structure shown in FIG. 4. For ease of description, in the current embodiment, an example in which a target application includes a first process and the computing node that performs the method in this embodiment of this application is a node that runs the first process is used for description. The method includes the following steps.

S101: Obtain a first trace log generated in a running process of the first process.

The first trace log includes at least one log record, each log record in the first trace log includes a function call record of calling a communication function by the first process. The function call record of calling a communication function by the first process includes the function name, the function parameter, and a record in which another communication function is included in or called by the communication function called by the first process. For detailed descriptions, refer to the foregoing descriptions of the "trace (trace) log". For descriptions of the communication function, refer to the foregoing descriptions of the "communication function". Details are not described again.

Optionally, the communication function called by the first process may be a function that communicates with another function in the first process, or may be a function that communicates with a process other than the first process. This is not limited.

Each log record in the first trace log further includes time data. In this embodiment of this application, the time data in the log record includes start time of calling the communication function and calling duration. Herein, the calling duration may also be understood as running duration of the called communication function. For any log record in the first trace log, for example, a first log record, it is assumed that a function call record in the first log record is a function call record of a first communication function called by the first process. In this case, time data of the first log record includes time at which the first process starts to call the first communication function and calling duration. The start time at which the first communication function starts to be called plus the calling duration may indicate time at which the first process ends/completes calling the first communication function.

In an example, it is assumed that, in the running process, the first process starts to call a communication function 0 at a moment t0, and ends calling the communication function 0 at a moment t1. In this case, in a process in which the computing node runs the first process that calls the communication function 0, the computing node may generate a log record 0, and time data in the log record 0 includes t0 and (t1-t0), where t0 indicates the time at which the first process starts to call the communication function 0, and (t1-t0) indicates duration in which the first process calls the communication function 0.

Optionally, it is assumed that a program of the target application is referred to as a target program. In this case, before running the target program via the first process, the computing node may modify an LD_PRELOAD environment variable of the target program, to implement dynamic library loading for collecting the trace log in the running process of the target program. Then, in the process of running the target program via the first process, the computing node may access, through a PMPI interface, the first trace log generated in the running process of the first process. For example, the computing node may copy, through the PMPI interface, the first trace log from storage space corresponding to a default file directory used to store the first trace log. For another example, the computing node may modify, through the PMPI interface, the default file directory of the storage space used to store the first trace log to a file directory of storage space that can be accessed by the process for performing the method in this embodiment of this application. This is not limited.

S102: Construct a first dictionary and a first grammar set based on the function call record in the first trace log, to compress the function call record in the first trace log.

The first dictionary includes at least one symbol string, and the first grammar set includes at least one grammar tree. A quantity of symbol strings in the first dictionary and a quantity of grammar trees in the first grammar set are the same as and one-to-one correspond to a quantity of log records in the first trace log.

For any log record in the first trace log, for example, the first log record, when the function call record in the first log record is referred to as a first function call record, a first symbol string that is in the first dictionary and that corresponds to the first log record indicates the first function call record, and a first grammar tree that is in the first grammar set and that corresponds to the first log record indicates a function call relationship in the first function call record. It can be learned that there is also a correspondence between the first symbol string and the first grammar tree.

The first dictionary further includes a first description information set, the first description information set includes at least one piece of description information, and the at least one piece of description information includes description information used to describe semantics of each symbol string in the first dictionary.

The following describes in detail a process in which the computing node constructs the first dictionary and the first grammar set based on the function call record in the first trace log. The process includes steps S1021 and S1022.

S1021: The computing node constructs, based on the function call record in each log record in the first trace log, a symbol string corresponding to each log record, to obtain the first dictionary corresponding to the first trace log.

First, for any log record in the first trace log, for example, the first log record, it is assumed that the function call record in the first log record is the first function call record. Optionally, the computing node may construct, based on a function name and a parameter value in each parameter item that are in the first function call record, the first symbol string indicating the first function call record. Optionally, the computing node may construct, based on a number corresponding to the function name and the parameter value in each parameter item that are in the first function call record, the first symbol string indicating the first function call record. In this case, data obtained by compressing the first trace log includes a correspondence between the function name and the number. For related descriptions of the parameter item, refer to the foregoing descriptions. Details are not described again.

In an example, the log record 0 described above is used as an example. The computing node may construct, based on a function call record in the log record 0, a symbol string 0 indicating the function call record in the log record 0:
"MPI _Isend;-1270915064;961;1275070475;4;1024;1140850688;160750800".

The symbol string 0 includes a function name "MPI_Isend" in the function call record in the log record 0, and includes a parameter value of each parameter item in the function call record in the log record 0.

In another example, the log record 0 described above is used as an example. The computing node may construct, based on the function call record in the log record 0, a symbol string 1 indicating the log record 0:
"01;-1270915064;961;1275070475;4;1024;1140850688;160750800".

"01" is a number corresponding to the function name "MPI_Isend" in the function call record in the log record 0.

In addition, when constructing, based on the function call record in the first log record, the first symbol string corresponding to the first log record, the computing node further generates, based on the function call record in the first log record, description information used to describe semantics of the first symbol string. The description information used to describe the semantics of the first symbol string is specifically a grammar for describing a parameter name of each parameter value in the first symbol string, and one parameter name may identify one type of parameter. A grammar for describing a parameter name of a parameter value may be referred to as a description grammar.

In an example, the log record 0 described above is used as an example. When the computing node generates the symbol string 0 "MPI_Isend;-1270915064;961;1275070475;4;1024;1140850688;160750800" based on the function call record in the log record 0, the computing node generates, based on the function call record in the log record 0, description information used to describe semantics of the symbol string 0: The 1^{st} parameter value is a value of a parameter "mpip_const_void_t buf", the 2^{nd} parameter value is a value of a parameter "int count", the 3^{rd} parameter value is a value of a parameter "MPI_Datatype datatype", the 4^{th} parameter value is a value of a parameter "Int dest", the 5^{th} parameter value is a value of a parameter "Int tag", the 6^{th} parameter value is a value of a parameter "MPI_Comm comm", and the 7^{th} parameter value is a value of a parameter "MPI_Request request". It can be learned that the description information used to describe the semantics of the symbol string 0 includes seven description grammars.

In some possible implementations, when function call records in at least two log records in the first trace log have same semantics, symbol strings that are in the first dictionary and that indicate the function call records in the at least two log records correspond to one piece of description information in the first description information set. In other words, in this embodiment of this application, one piece of description information in the first description information set indicates the symbol strings that are in the first dictionary and that indicate the function call records in the at least two log records.

For example, the function call record in the first log record in the first trace log is the first function call record, and a function call record in a second log record in the first trace log is a second function call record. That the first function call record and the second function call record have same semantics means that a plurality of types of parameters indicated by all parameter items in the first function call record are the same as a plurality of types of parameters indicated by all parameter items in the second function call record in a one-to-one correspondence. It should be understood that parameters with a same parameter name are a same type of parameter. In this way, parameter items that are in the first function call record and the second function call record and that indicate a same type of parameter have same parameter names, but may have a same parameter value or different parameter values. This is not limited. Therefore, when function call records in a plurality of log records have same semantics, a plurality of symbol strings corresponding to the plurality of log records are different, but the symbol strings may share one piece of description information. In this case, in the process of compressing the function call record in the first trace log by constructing the first dictionary, the computing node further needs to separately establish a correspondence between a plurality of symbol strings that share one piece of description information and the description information. Based on this, the function call record in the first trace log can be further compressed.

In an example, with reference to the log record 0, it is assumed that a function call record that is of the log record 1 and that is obtained by the computing node includes seven parameter items that indicate parameters "mpip_const_void_t buf", "int count", "MPI_Datatype datatype", "Int dest", "Int tag", "MPI_Comm comm", and "MPI_Request request". It can be learned that the seven types of parameters indicated by all the parameter items in the function call record in the log record 1 are the same as the seven types of parameters indicated by all the parameter items in the function call record in the log record 0 in a one-to-one correspondence. When parameter items that are in the log record 0 and the log record 1 and that indicate a same type of parameter have different parameter values, the symbol string 0 indicating the function call record in the log record 0 is different from a symbol string 1 indicating the function call record in the log record 1. However, the description information that describes the semantics of the symbol string 0 is the same as description information that describes semantics of the symbol string 1. Therefore, the symbol string 0 and the symbol string 1 share one piece of description information. Further, in the process of compressing the first trace log by constructing the first dictionary, the computing node further separately establishes a correspondence between the shared description information and the symbol string 0, and a correspondence between the shared description information and the symbol string 1.

In this way, the first dictionary corresponding to the first trace log can be obtained by performing S1021 to construct the corresponding symbol string and description information for each log record in the first trace log.

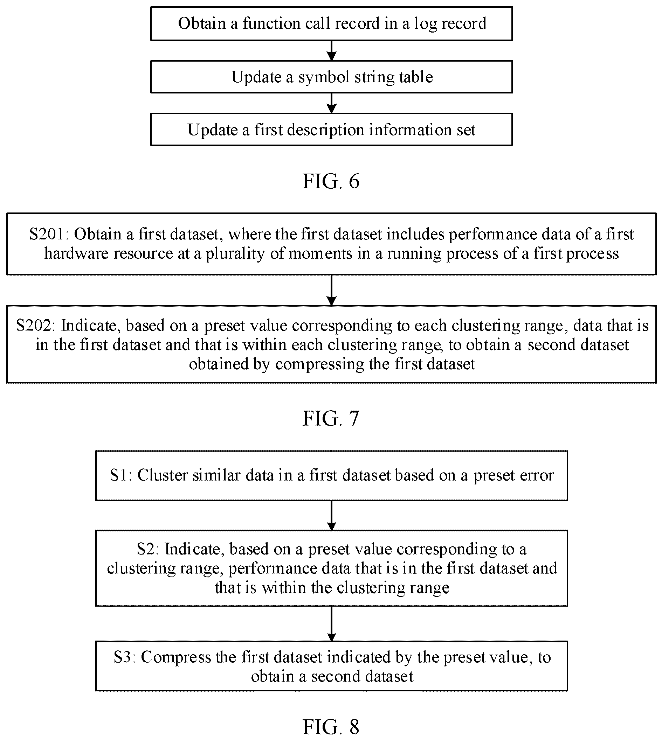

In some examples, FIG. 6 is a block diagram of the process of constructing the first dictionary corresponding to the first trace log according to an embodiment of this application.

It is assumed that a process that is in the computing node and that performs the method in this embodiment of this application is briefly referred to as a compression process. As shown in FIG. 6, the compression process first obtains a function call record in a 1^{st} log record in the first trace log, constructs a corresponding symbol string 1, then writes the symbol string 1 into a symbol string table, constructs description information 1 that describes semantics of the symbol string 1, writes the description information 1 into the first description information set, and establishes a correspondence between the symbol string 1 and the description information 1. The symbol string table is used to write a symbol string indicating the function call record in each log record in the first trace log.

Then, the compression process obtains a function call record in a 2^{nd} log record in the first trace log, constructs a corresponding symbol string 2, and then writes the symbol string 2 into the symbol string table, to update the symbol string table, constructs description information 2 that describes semantics of the symbol string 2, and writes the description information 2 into the first description information set, to update the first description information set, and establishes a correspondence between the symbol string 2 and the description information 2.

Then, the compression process obtains a function call record in a 3^{rd} log record in the first trace log, constructs a corresponding symbol string 3, and writes the symbol string 3 into the symbol string table, to update the symbol string table. It is assumed that semantics of the function call record in the 3^{rd} log record is the same as the semantics of the function call record in the 1^{st} log record. In this case, a correspondence between the symbol string 3 and the description information 1 is established, and the first description information set remains unchanged.

Similarly, the compression process performs the process shown in FIG. 6 on each log record in the first trace log, to obtain the first dictionary corresponding to the first trace log.

S1022: The computing node constructs, based on the function call record in each log record in the first trace log, a grammar tree corresponding to each log record, to obtain the first grammar set corresponding to the first trace log.

Specifically, for the first function call record in the first log record in the first trace log, the computing node may use a communication function indicated by the function name in the first function call record as a root, use a communication function included or called in the first function call record as a child, and construct, based on a quantity of running times of the communication function included or called in the first function call record, a grammar tree corresponding to the first log record. The grammar tree corresponding to the first log indicates the function call relationship in the first function call record.

The communication function indicated by the function name in the first function call record may be referred to as a root function (namely, a communication function directly called by the first process). In this case, "the communication function included or called in the first function call record" is a communication function included in the root function or a communication function called by the root function. Herein, "the communication function called by the root function" may be a function that communicates with another function in the first process, or may be a function that communicates with a process other than the first process. This is not limited. It should be understood that the root function may call one or more functions that communicate with another function or process, and the communication function called by the root function may also call a communication function. This is not limited.

In an example, the first process generates a log record 1 in a process of calling a communication function 1, and a function call record in the log record 1 includes: A record in which the communication function 1 calls a communication function 2 and the communication function 2 is executed three times, a record in which the communication function 1 calls a communication function 3 and the communication function 3 is executed once, a record in which the communication function 2 calls a communication function 4 and the communication function 4 is executed 10 times, a record in which the communication function 1 includes a communication function 5 and the communication function 5 is executed twice, a record in which the communication function 5 calls a communication function 6 and the communication function 6 is executed twice, and a record in which a communication function 7 in the communication function 1 is called by another function/process and the communication function 7 is executed eight times when the communication function 7 is called.

In this case, the computing node constructs, based on the function call record in the log record 1, a grammar tree 1 indicating a function call relationship in the function call record: "communication function 1->communication function 2^3, communication function 1->communication function 3^1, communication function 2->communication function 4^10, communication function 5^2, communication function 5->communication function 6^2, and -communication function 7^8". Information on the left of "->" indicates a parent function in the function call relationship, information on the right of "->" indicates a subfunction in the function call relationship, and "^value a" indicates that a quantity of execution times is a. Therefore, "communication function 1->communication function 2^3" may indicate that the communication function 1 calls the communication function 2 and executes the communication function 2 three times, "communication function 5^2" indicates that the communication function 5 is autonomously executed twice, and "-communication function 7^8" indicates that the communication function 7 is called, and the communication function 7 is executed eight times when the communication function 7 is called.

In some possible cases, in the process in which the first process calls the first communication function, the first communication function does not include another communication function, and the first communication function does not call another communication function. In this case, for the first log record generated by the computing node in the process in which the first process calls the first communication function, the grammar tree constructed by the computing node based on the function call record in the first log record includes only a root function node.

In an example, in a process in which the first process calls the communication function 2, there is no other communication function in the communication function 2, and the communication function 2 does not call another communication function. In this case, the computing node generates a log record 2 in the process in which the first process calls the communication function 2, and a grammar tree 2 constructed based on a function call record in the log record 2 is "communication function 2^1", where "communication function 2^1" indicates that the communication function 2 is autonomously executed once.

To improve a compression rate, in this embodiment of this application, before the first process runs, communication functions included in the first process may be first numbered, and correspondences between these communication functions and numbers indicating these communication functions are established. In this way, in this embodiment of this application, when the grammar tree corresponding to the log record is constructed, each function node in the grammar tree is indicated by a number of the communication function. In this case, a file obtained by compressing the first trace log needs to include a correspondence between a communication function and a number indicating the communication function.

With reference to the foregoing example, it is assumed that in correspondences that are between the communication functions and numbers and that are pre-constructed by the computing node are as follows: The number of the communication function 1 is 1, the number of the communication function 2 is 2, the number of the communication function 3 is 3, the number of the communication function 4 is 4, the number of the communication function 5 is 5, the number of the communication function 6 is 6, and the number of the communication function 7 is 7. In this case, the grammar tree 1 may be "1->2^3, 1->3^1, 2->4^10, 5^2, 5->6^2, and -7^8". The grammar tree 2 may be "2^1".

It can be learned that a large quantity of communication functions included or called in the function call record in the first trace log and a large quantity of execution times of the communication functions included or called in the function call record indicate a high compression rate of compressing, by using the grammar tree, records of the communication functions included or called in the function call record in the first trace log.

In this way, the first grammar set corresponding to the first trace log can be obtained by performing S1022 to construct the corresponding grammar tree for each log record in the first trace log.

It should be understood that the process in which the computing node constructs the first dictionary and the first grammar set based on the function call record in the first trace log is to compress the function call record in the first trace log. Therefore, during decompression, the function call record in each log record in the first trace log can be recovered by using the first dictionary and the first grammar set.

It should be further understood that a sequence of performing S1021 and S1022 is not specifically limited in this embodiment of this application. For example, S1021 may be performed before S1022. Alternatively, S1022 is performed before S1021. Alternatively, S1021 and S1022 are simultaneously performed. This is not limited herein.

S103 (optional): Compress time data in the first trace log based on same calling duration in the first trace log.

Log records generated by the first process based on the called communication functions in the running process have basically different time at which the first process starts to call the communication functions and time at which the first process ends calling the communication functions. However, running duration of the communication functions is much the same or similar. In other words, calling duration in which the first process calls the communication functions is much the same or similar.

In this way, because the time data in the log record in this embodiment of this application includes the time at which the communication function starts to be called and the calling duration, the time data in the log record provided in this embodiment of this application includes a large amount of repeated or similar calling duration. In other words, the time data in the log record provided in this embodiment of this application includes a large quantity of repeated or similar character strings.

Therefore, the computing node may compress the time data in the first trace log based on the same or similar calling duration in all log records in the first trace log, so that a high compression rate can be obtained.

Optionally, the computing node may compress the time data in the first trace log in any lossy compression manner based on the same or similar calling duration in all the log records in the first trace log. This is not limited.

In this way, the trace log generated in the running process of the first process can be compressed by performing S101 to S103. The function call record in the trace log is compressed by constructing the first dictionary and the first grammar set, and the time data in the trace log is indicated by using the time at which the communication function starts to be called and the calling duration. Therefore, the time data in the trace log can indicate the time at which the communication function starts to be called and the time at which calling of the communication function ends, and a large quantity of repeated character strings (namely, the repeated calling duration) are enabled to be generated in the time data in the trace log, so that the compression rate of compressing the time data in the trace log is high. It can be learned that, in the method provided in this embodiment of this application, different compression processing is performed on different data in the trace log, so that the compression rate of compressing the trace log can be greatly improved, and compression duration can be shortened.

It can be learned that the compressed file obtained by compressing the trace log of the first process in S101 to S103 includes the first dictionary, the first grammar tree, the correspondence between the communication function of the first process and the number, and the compressed time data.

In some other embodiments, when performance analysis is performed on the program of the target application, in addition to analyzing the trace log generated in the running process of the process of the target application, hardware performance data used to run the process in the running process of the process of the target application is further analyzed. In this case, to reduce resources for storing or transmitting the hardware performance data, the hardware performance data may be compressed by using the following method in embodiments of this application.

FIG. 7 is a schematic flowchart of another data compression method according to an embodiment of this application. Optionally, the method may be performed by a computing node having the hardware structure shown in FIG. 4. For ease of description, in the current embodiment, an example in which a target application includes a first process, the computing node that performs the method in this embodiment of this application is a node that runs the first process, and a hardware resource occupied by the first process in the first process is a first hardware resource is used for description. The method includes the following steps.

S201: Obtain a first dataset, where the first dataset includes performance data of the first hardware resource at a plurality of moments in a running process of the first process.

The first dataset includes a plurality of groups of performance data (or referred to as hardware performance data) of the first hardware resource, and each group of performance data includes but is not limited to one or more of the following: instructions per cycle (instructions per cycle, IPC), a cache miss rate (cache miss rate, CMR), a cache hit rate (cache hit rate, CHR), and a branch misprediction rate (branch misprediction rate, BMR).

In a possible implementation, in the running process of the first process, the computing node may read the performance data of the first hardware resource from a performance monitor unit (performance monitor unit, PMU) of the computing node at a preset frequency. The performance data read by the computing node from the PMU each time is one group of performance data described above.

In another possible implementation, in the running process of the first process, the computing node may read the performance data of the first hardware resource from the PMU of the computing node at a moment at which each log record is generated. Performance data read by the computing node from the PMU at a moment at which the computing node generates a log record is one group of performance data described above.

S202: Indicate, based on a preset value corresponding to each clustering range, data that is in the first dataset and that is within each clustering range, to obtain a second dataset obtained by compressing the first dataset.

Due to an inherent error of the PMU, similar data in a same type of performance data read by the computing node from the PMU may be considered as the same. For example, in a plurality of CMRs read by the computing node, 80.5%, 81%, 79%, and 79.5% are all considered as a same CMR.

Therefore, in a first possible implementation, the computing node presets a plurality of preset ranges for each type of performance data, and each preset range corresponds to one preset value. For any preset range, a preset value corresponding to the preset range may be a number, an ID, or a median of the preset range that is set by the computing node for the preset range. A size of each preset range is not specifically limited in this embodiment of this application. For example, the size of each preset range may be determined with reference to the inherent error of the PMU.

In this way, when the computing node sets a plurality of preset ranges for any type of performance data (for example, a first type of performance data) in the first dataset, data that is in the first type of performance data and that is within a first preset range in the plurality of preset ranges may be indicated based on a preset value corresponding to the first preset range. The first preset range is any one of the plurality of preset ranges.

In an example, for the CMR, the computing node sets a preset range 1 [0, 70%), a preset range 2 [70%, 75%), a preset range 3 [75%, 80%), a preset range 4 [80%, 85%), a preset range 5 [85%, 90%), and a preset range 6 [90%, 100%). In addition, a preset value corresponding to the preset range 1 is 11, a preset value corresponding to the preset range 2 is 12, a preset value corresponding to the preset range 3 is 13, a preset value corresponding to the preset range 4 is 14, a preset value corresponding to the preset range 5 is 15, and a preset value corresponding to the preset range 6 is 16. In this case, when the computing node determines that a CMR 1 in the first dataset is within the preset range 2, the computing node indicates the CMR 1 based on 12.

In this way, the first dataset in which the performance data is indicated based on the preset value includes a large amount of repeated data. Further, the computing node may compress the first dataset including the large amount of repeated data obtained by indicating all the performance data based on the preset values, to obtain the second dataset.

Optionally, the computing node may compress, based on the lzma (Lempel-Ziv-Markov chain-Algorithm) compression algorithm, the first dataset including the large amount of repeated data, to obtain the second dataset.

In a second possible implementation, the computing node may cluster each type of performance data in the first dataset based on a preset error. A difference between any two pieces of performance data clustered into one type is less than the preset error. In this way, performance data clustered into one type may be referred to as performance data in one clustering range. A value of the preset error is not specifically limited in this embodiment of this application. For example, the preset error may be set with reference to the inherent error of the PMU.

Then, the computing node sets a preset value for each clustering range. Herein, for descriptions in which the computing node sets a preset value for each clustering range, refer to the foregoing descriptions of setting the preset value for each preset range. Details are not described again.

Then, the computing node may indicate, based on the preset value corresponding to each clustering range, performance data that is in the first dataset and that is within the clustering range. In this way, after the performance data that is in the first dataset and that is within each clustering range is indicated based on the preset value corresponding to each clustering range, the first dataset includes a large amount of repeated data.

Further, the computing node compresses the first dataset including the large amount of repeated data, for example, compresses the first dataset by using the lzma compression algorithm, to obtain the second dataset.

In terms of specific implementation of the second possible design, FIG. 8 is a block diagram of a process of compressing the first dataset. The process may be implemented through the following steps:
S1: Cluster similar data in the first dataset based on the preset error.
S2: Indicate, based on the preset value corresponding to the clustering range, the performance data that is in the first dataset and that is within the clustering range.
S3: Compress the first dataset indicated by the preset value, to obtain the second dataset.

In this way, according to the method described in S201 and S202, the computing node compresses the performance data of the first hardware resource in the running process of the first process. The similar data in the first dataset is indicated based on the preset value and with reference to the inherent error of the PMU that monitors the hardware resource performance data. In this way, the large amount of same data can be generated in the first dataset, so that a compression rate of compressing the first dataset can be improved, and compression time can be shortened.

In still some embodiments, the target application includes a plurality of processes, and a trace log generated in a running process of each process is compressed by using the method described in S101 to S103. To improve a compression rate of compressing the trace logs generated by the plurality of processes of the target application, the trace logs generated by the processes of the target application may be compressed by using the method described in S101 to S103, and the trace logs generated by the plurality of processes of the target application are further compressed based on a difference between the trace logs of the plurality of processes.

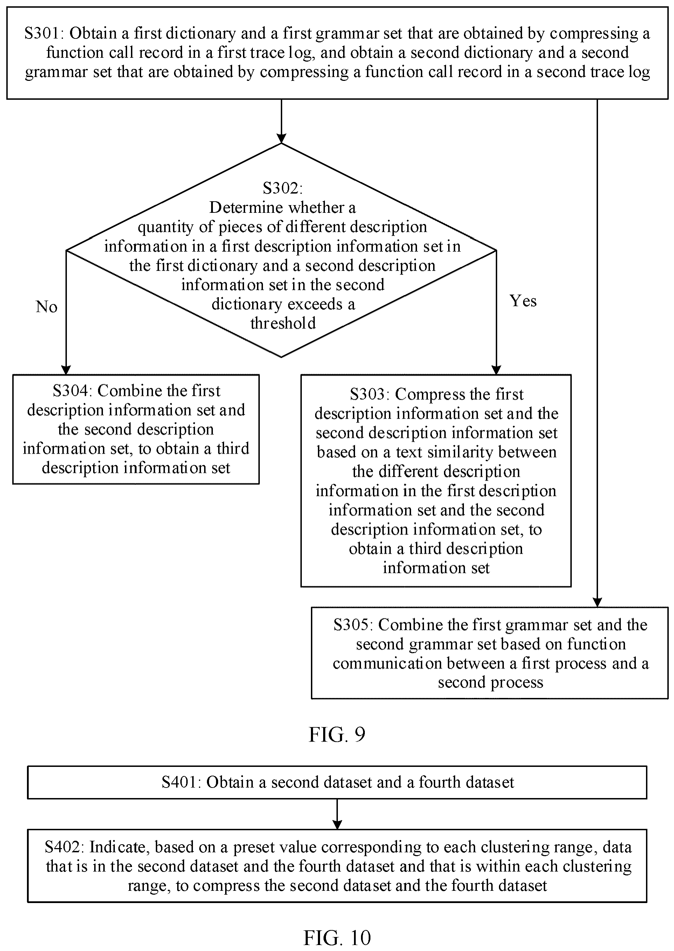

FIG. 9 is a schematic flowchart of still another data compression method according to an embodiment of this application. Optionally, the method may be performed by a computing node having the hardware structure shown in FIG. 4. For ease of description, in the current embodiment, an example in which a target application includes a first process and a second process, a first trace log is generated in a running process of the first process, and a second trace log is generated in a running process of the second process is used for description. The first process and the second process may run on a same node, or may run on different nodes. This is not limited. The method includes the following steps.

S301: Obtain a first dictionary and a first grammar set that are obtained by compressing a function call record in the first trace log, and obtain a second dictionary and a second grammar set that are obtained by compressing a function call record in the second trace log.

For a process in which the computing node obtains the first trace log generated in the running process of the first process, and obtains the first dictionary and the first grammar set by compressing the function call record in the first trace log, and detailed descriptions of the first dictionary and the first grammar set, refer to the foregoing descriptions in S101 and S102. Details are not described herein again.

Similarly, for detailed descriptions in which the computing node obtains the second trace log generated in the running process of the second process, and obtains the second dictionary and the second grammar set by compressing the function call record in the second trace log, refer to the descriptions in which the computing node obtains the first trace log generated in the running process of the first process, and obtains the first dictionary and the first grammar set by compressing the function call record in the first trace log. Details are not described again.

The second dictionary includes at least one symbol string, and the second grammar set includes at least one grammar tree. A quantity of symbol strings in the second dictionary and a quantity of grammar trees in the second grammar set are the same as and one-to-one correspond to a quantity of log records in the second trace log. For any log record in the second trace log, for example, a second log record, when a function call record in the second log record is referred to as a second function call record, a second symbol string that is in the second dictionary and that corresponds to the second log record indicates the second function call record, and a second grammar tree that is in the second grammar set and that corresponds to the second log record indicates a function call relationship in the second function call record. It can be learned that there is also a correspondence between the second symbol string and the second grammar tree.

The second dictionary further includes a second description information set, the second description information set includes at least one piece of description information, and the at least one piece of description information includes description information used to describe semantics of each symbol string in the second dictionary.

It should be noted that, in a scenario in which the target application includes the first process and the second process, when the computing node constructs the grammar tree in the first grammar set and the grammar tree in the second grammar set, numbers of used communication functions are unique in a domain including the first process and the second process. In this way, the grammar tree constructed by the computing node can clearly record a function call relationship between the first process and the second process.

Therefore, when the target application includes the first process and the second process, before running the two processes, the computing node first numbers communication functions respectively included in the first process and the second process, and establishes correspondences between these communication functions and numbers indicating these communication functions. When the first process and the second process call a same communication function, because the communication function is called by different processes, the communication function corresponds to different numbers in the first process and the second process, to distinguish between the processes that call and run the communication function.

Optionally, the computing node may separately number the communication functions included in the first process and the second process. For example, the computing node may number the communication function included in the first process by using a value in a first number segment, and number the communication function included in the second process by using a value in a second number segment. In addition, the computing node further establishes a correspondence between the communication function included in the first process and the corresponding number, and establishes a correspondence between the communication function included in the second process and the corresponding number. The first number segment and the second number segment are different data segments. For example, the first number segment ranges from 1 to 100, and the second number segment ranges from 101 to 200. This is not limited thereto.

S302: Determine whether a quantity of pieces of different description information in the first description information set in the first dictionary and the second description information set in the second dictionary exceeds a threshold.

The quantity of pieces of different description information in the first description information set and the second description information set indicates a quantity of symbol strings that have different semantics in the first dictionary and the second dictionary.

When the quantity of pieces of different description information in the first description information set and the second description information set is large, for example, exceeds the preset threshold, it indicates that the quantity of symbol strings that have different semantics in the first dictionary and the second dictionary is large. In this case, the computing node may perform S305, to improve a compression rate of compressing the trace logs generated by the plurality of processes.

When the quantity of pieces of different description information in the first description information set and the second description information set is small, for example, less than the preset threshold, it indicates that the quantity of symbol strings that have different semantics in the first dictionary and the second dictionary is small. In this case, the computing node may perform S304, to shorten compression time for compressing the trace logs generated by the plurality of processes.

A specific value of the threshold is not specifically limited in this embodiment of this application.

S303: Compress the first description information set and the second description information set based on a text similarity between the different description information in the first description information set and the second description information set, to obtain a third description information set.

Specifically, the computing node compresses the different description information based on the text similarity between the different description information in the first description information set and the second description information set and by using a longest common subsequence (Longest Common Subsequence, LCS) algorithm, to obtain one or more pieces of compressed description information. One piece of compressed description information is obtained by compressing at least two pieces of different description information from the first dictionary and the second dictionary.

It should be understood that, when the different description information is compressed by using the LCS algorithm, it may be understood that a repeated description grammar in the different description information is deleted. Herein, for descriptions of the description grammar, refer to the foregoing descriptions. Details are not described again.

In an example, description information 1 that describes semantics of a symbol string 1 in the first dictionary is as follows: A 1^{st} parameter value is a value of a parameter a, a 2^{nd} parameter value is a value of a parameter b, and a 3^{rd} parameter value is a value of a parameter c. Description information 2 that describes semantics of a symbol string 2 in the second dictionary is as follows: A 1^{st} parameter value is a value of a parameter d, a 2^{nd} parameter value is a value of a parameter b, a 3^{rd} parameter value is a value of a parameter c, a 4^{th} parameter value is a value of a parameter e, and a 5^{th} parameter value is a value of a parameter f. It can be learned that the description information 1 and the description information 2 are different, but the description information 1 and the description information 2 include a same grammar: The 2^{nd} parameter value is the value of the parameter b, and the 3^{rd} parameter value is the value of the parameter c. Therefore, based on the LCS algorithm, the computing node may compress the description information 1 and the description information 2, to obtain compressed description information: The 1^{st} parameter value is the value of the parameter a, the 2^{nd} parameter value is the value of the parameter b, the 3^{rd} parameter value is the value of the parameter c, the 1^{st} parameter value is the value of the parameter d, the 4^{th} parameter value is the value of the parameter e, and the 5^{th} parameter value is the value of the parameter f. In this case, the compressed description information further includes indication information indicating that the first three description grammars in the compressed description information are used to describe the semantics of the symbol string 1, and the last five description grammars are used to describe the semantics of the symbol string 2.

In addition, for same description information in the first description information set and the second description information set, the computing node deletes repeated description information from the same description information, to implement redundancy removal of the description information.

In an example, when the first description information set includes the description information 1 used to describe the symbol string 1 in the first dictionary, the second description information set includes the description information 2 used to describe the symbol string 2 in the second dictionary, and it is assumed that the description information 1 is the same as the description information 2, in a process of compressing the first trace log and the second trace log, the computing node deletes the description information 1 or the description information 2, to remove redundancy from the description information 1 and the description information 2 that are the same.

In this way, the third description information set may be formed by the one or more pieces of compressed description information obtained based on the different description information in the first description information set and the second description information set and the description information retained by removing redundancy from the same description information. The third description information set includes description information used to describe semantics of each symbol string in the first dictionary and the second dictionary, and there is no repeated description information or description grammar.

Further, for the description information retained by removing redundancy from the same description information, the computing node further establishes a correspondence between the description information and the corresponding symbol string in the first trace log, and establishes a correspondence between the description information and the corresponding symbol string in the second trace log. In this way, when decompressing the first trace log and the second trace log, the computing node may recover the corresponding symbol string in the first trace log and the corresponding symbol string in the second trace log based on the description information retained through redundancy removal.

In an example, when the first description information set includes the description information 1 used to describe the symbol string 1 in the first dictionary, the second description information set includes the description information 2 used to describe the symbol string 2 in the second dictionary, the description information 1 is the same as the description information 2, and the computing node deletes the description information 1 to implement redundancy removal, the computing node further establishes a correspondence between the description information 2 retained through redundancy removal and the symbol string 1 of the first dictionary, and establishes a correspondence between the description information 2 and the symbol string 2 of the second dictionary.

S304: Combine the first description information set and the second description information set, to obtain a third description information set.

Specifically, the computing node performs redundancy removal processing on same description information in the first description information set and the second description information set. For detailed descriptions, refer to the related descriptions in S303. Details are not described again.

For a small amount of different description information in the first description information set and the second description information set, the computing node directly determines, as the third description information set, this part of description information and description information retained through redundancy removal processing, and establishes a correspondence between the description information and the corresponding symbol string. It can be learned that the third description information set includes description information used to describe semantics of each symbol string in the first dictionary and the second dictionary.

The third description information is obtained in this manner, so that compression time for compressing the function call record in the first trace log and the function call record in the second trace log can be saved.

In this way, by performing S301 to S304, the computing node further compresses the first description information set and the second description information set in different manners based on the quantity of pieces of different description information in the first description information set and the second description information set, so that the function call record in the first trace log and the function call record in the second trace log are further compressed, and the compression rate of compressing the first trace log and the second trace log is improved.

Optionally, after S301, the method may further include:
S305: Combine the first grammar set and the second grammar set based on function communication between the first process and the second process.

When communication function call exists between the first process and the second process, function nodes with same semantics may exist in the grammar tree in the first grammar set and the grammar tree in the second grammar set. The communication function call between the processes can implement communication between the processes.

In an example, it is assumed that a number segment ranging from 0 to 100 is used when the communication function of the first process is numbered, and a number segment ranging from 101 to 200 is used when the communication function of the second process is numbered. With reference to the foregoing example, a grammar tree 1 in the first grammar set is "1->2^3, 1->3^1, 2->4^10, 5^2, 5->6^2, and -7^8", where "-7^8" indicates that a communication function numbered 7 (namely, the communication function 7 described above) is called, and is executed eight times. When a grammar tree 2 in the second grammar set is "101->7^8 and 105^5", "101->7^8" indicates that a communication function numbered 101 calls a communication function 7 and executes the communication function 7 eight times, and "105^5" indicates that a communication function numbered 105 is autonomously executed five times. It can be learned that the function node "-7^8" in the grammar tree 1 and the function node "101->7"8" in the grammar tree 2 have same semantics: The communication function 7 is called, and is executed eight times.

Further, the computing node may fuse grammar trees that are in the first grammar set and the second grammar set and that include function nodes that have same semantics, to implement combination of the first grammar set and the second grammar set. In this way, redundancy removal can be performed on the function nodes that have the same semantics in the first grammar set and the second grammar set. In addition, the computing node further establishes correspondences between different function nodes in a fused grammar tree and a plurality of symbol strings. Herein, the plurality of symbol strings are symbol strings respectively corresponding to the plurality of grammar trees before fusion.

With reference to the foregoing example, the computing node may combine and fuse the grammar tree 1 "1->2^3, 1->3^1, 2->4^10, 5^2, 5->6^2, and -7^8" in the first grammar set and the grammar tree 2 "101->7^8 and 105^5" in the second grammar set, to obtain a fused grammar tree 3 "1->2^3, 1->3^1, 2->4^10, 5^2, 5->6^2, 101->7^8, and 105^5". In addition, when the grammar tree 1 corresponds to the symbol string 1 in the first dictionary, and the grammar tree 2 corresponds to the symbol string 2 in the second field, the computing node further establishes a correspondence between the first six function nodes in the grammar tree 3 and the symbol string 1, and a correspondence between the last two function nodes and the symbol string 2.

In this way, redundancy removal can be performed on the first grammar set and the second grammar set by performing S301 and S305, to compress the first grammar set and the second grammar set, and further improve the compression rate of compressing the function call record in the first trace log and the function call record in the second trace log.

In addition, in the scenario in which the target application includes the first process and the second process, it is assumed that time data of the first trace log generated in the running process of the first process is referred to as first time data, and time data of the second trace log generated in the running process of the second process is referred to as second time data. For detailed descriptions of the second time data, refer to the foregoing descriptions of the time data of the first trace log. Details are not described again.

In S103, the computing node has compressed the first time data. In addition, the computing node may compress the second time data with reference to S103. Further, the computing node may further compress the compressed first time data and the compressed second time data, to improve the compression rate of compressing the trace log of the target application. For example, the computing node may further compress the compressed first time data and the compressed second time data by using a general compression algorithm. Details are not described again.

Certainly, the computing node may alternatively first obtain the first time data and the second time data that are recorded in a format described in this application, and then simultaneously compress the obtained first time data and second time data. This is not limited.

In still some possible embodiments, when the target application includes a plurality of processes, in embodiments of this application, hardware performance data obtained in a running process of each process may be further compressed, to improve the compression rate.

FIG. 10 is a schematic flowchart of yet another data compression method according to an embodiment of this application. Optionally, the method may be performed by a computing node having the hardware structure shown in FIG. 4. For ease of description, in the current embodiment, an example in which a target application includes a first process and a second process, a hardware resource occupied by the first process is a first hardware resource, and a hardware resource occupied by the second process is a second hardware resource is used for description. The first process and the second process may run on a same node, or may run on different nodes. This is not limited. The method includes the following steps.

S401: Obtain a second dataset and a fourth dataset.

The second dataset is obtained by compressing a first dataset obtained in a running process of the first process. For a specific process, refer to the foregoing descriptions in S201 and S202. For detailed descriptions of the first dataset, refer to the related descriptions in S201. Details are not described again.

The fourth dataset is obtained by compressing a third dataset obtained in a running process of the second process, the third dataset includes a plurality of groups of performance data of the second hardware resource in the running process of the second process, and each group of performance data includes but is not limited to one or more of the following: IPC, a CMR, a CHR, and a BMR. For a process in which the computing node obtains the fourth dataset by compressing the third dataset, refer to the foregoing descriptions in which the computing node obtains the second dataset by compressing the first dataset in S201 and S202. Details are not described again.

S402: Indicate, based on a preset value corresponding to each clustering range, data that is in the second dataset and the fourth dataset and that is within each clustering range, to compress the second dataset and the fourth dataset.

In a possible design, when the second dataset and the fourth dataset are obtained based on the first possible implementation in S202, the second dataset and the fourth dataset may include a same preset value. Therefore, the computing node may directly further compress the second dataset and the fourth dataset in a general compression manner (for example, lzma).

In another possible design, when the second dataset and the fourth dataset are obtained based on the second possible implementation in S202, the computing node may cluster each type of performance data in the second dataset and the fourth dataset based on the preset error. A difference between any two pieces of performance data clustered into one type is less than the preset error. Then, the computing node sets a preset value for each clustering range, and indicates, based on the preset value corresponding to each clustering range, performance data that is in the second dataset and the fourth dataset and that is within each clustering range.

Further, the computing node compresses the second dataset and the fourth dataset that are indicated by the preset value, for example, compresses the second dataset and the fourth dataset by using the lzma compression algorithm, to obtain compressed datasets.

In this way, the hardware performance data obtained in the running processes of the plurality of processes is further compressed by performing S401 and S402. This improves a data compression rate.

Certainly, in the scenario in which the target application includes the plurality of processes, after obtaining the first dataset corresponding to the first process and the third dataset corresponding to the second process, the computing node may perform S202 on the first dataset and the third dataset, to compress the hardware performance data obtained in the running processes of the plurality of processes.

The following describes, based on experimental data, beneficial effect brought by the method in embodiments of this application.

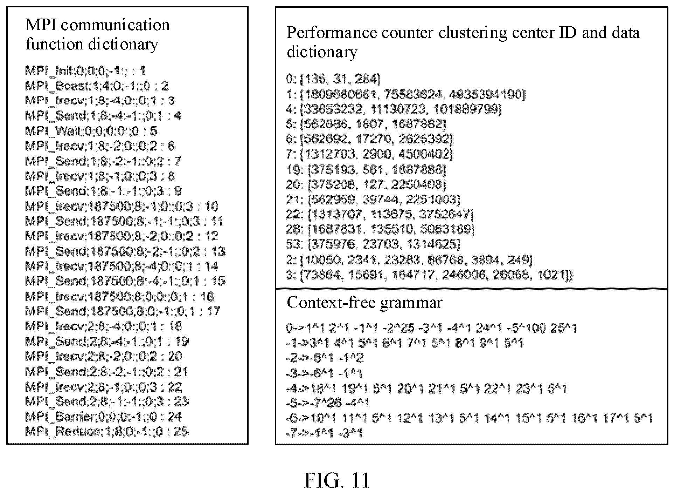

In an example, FIG. 11 is a diagram of a compression result obtained by performing data compression by using a method according to an embodiment of this application.

As shown in FIG. 11, the compression result includes an MPI communication function dictionary, and the MPI communication function dictionary includes a dictionary (refer to the first dictionary, the second dictionary, and the like described above) corresponding to each process in a target application. A context-free grammar is a grammar set obtained by combining and compressing grammar sets corresponding to trace logs generated by the processes of the target application (refer to S305). A performance counter clustering center ID and a data dictionary includes the preset value and the performance data within the preset range/clustering range corresponding to each preset value that are described above. For example, for "0: [136, 31, 264]", "0" indicates a preset value, and "[136, 31, 264]" indicates three pieces of performance data within a preset range/clustering range corresponding to the preset value "0".

In another example, as shown in Table 1, Table 1 shows related information of nine programs that comply with an MPI protocol. A conjugate gradient (Conjugate Gradient, CG) method and a multi-grid (Multi-Grid, MG) are computing cores in two network attached storage (Network Attached Storage, NAS) parallel benchmarks (NAS Parallel Benchmark, NPB). A block tri-diagonal solver (Block Tri-diagonal solver, BT), a scalar penta-diagonal solver (Scalar Penta-diagonal solver, SP), and a lower-upper Gauss-Seidel solver (Lower-Upper Gauss-Seidel solver, LU) are three pseudo applications in the NPB. Sweep3d (Sweep3d) is a simulation program that describes a neutron transfer problem in three-dimensional space. Sedov, StirTurb, and Sod are three classic problems in FLASH. FLASH is a software package that solves a fluid problem.

An amount of input and output data of a problem size in NPB 3.3.1 is set to D, a size of the three problems in FLASH simulation is set to 64*64*64, and an input scale in Sweep3d is set to 1000*1000*1000. In addition to the name of each test program, Table 1 further shows a quantity of concurrent processes (processes), a quantity of events (events), a trace log size (trace size), a quantity of unique grammars (unique grammars), and the like of each test program.

**Table 1**

| Test program | Quantity of concurrent processes | Quantity of events | Trace log size/MB | Quantity of unique grammars |
|---|---|---|---|---|
| CG | 64 | 5,100,352 | 491 MB | 1 |
| | 128 | 13,264,640 | 1,255 MB | 1 |
| | 256 | 26,529,280 | 2,534 MB | 1 |
| | 512 | 65,314,304 | 6,223 MB | 1 |
| MG | 64 | 1,641,568 | 168 MB | 8 |
| | 128 | 3,101,984 | 318 MB | 12 |
| | 256 | 6,032,608 | 618 MB | 18 |
| | 512 | 11,913,440 | 1,294 MB | 27 |
| BT | 64 | 2,909,376 | 290 MB | 1 |
| | 121 | 7,687,251 | 767 MB | 1 |
| | 256 | 23,974,656 | 2,367 MB | 1 |
| | 529 | 71,848,251 | 6,962 MB | 1 |
| SP | 64 | 4,458,560 | 508 MB | 64 |
| | 121 | 11,702,999 | 1,317 MB | 121 |
| | 256 | 36,303,104 | 4,024 MB | 256 |
| | 529 | 108,410,615 | 11,662 MB | 529 |
| LU | 64 | 54,954,468 | 5,696 MB | 9 |
| | 128 | 113,834,108 | 11,645 MB | 9 |
| | 256 | 235,518,548 | 23,849 MB | 9 |
| | 512 | 478,887,428 | 48,059 MB | 9 |
| Sweep3d | 64 | 7,171,584 | 780 MB | 3 |
| | 128 | 14,855,168 | 1,612 MB | 3 |
| | 256 | 30,734,336 | 3,320 MB | 3 |
| | 512 | 62,492,672 | 6,669 MB | 3 |
| Sedov | 64 | 167,892 | 16 MB | 2 |
| | 128 | 335,764 | 32 MB | 2 |
| | 256 | 671,508 | 64 MB | 2 |
| | 512 | 1,342,996 | 135 MB | 2 |
| StirTurb | 64 | 3,199,252 | 304 MB | 2 |
| | 128 | 6,398,484 | 614 MB | 2 |
| | 256 | 12,796,948 | 1,241 MB | 2 |
| | 512 | 25,593,876 | 2,510 MB | 2 |
| Sod | 64 | 60,372 | 6 MB | 2 |
| | 128 | 120,724 | 12 MB | 2 |
| | 256 | 241,428 | 24 MB | 2 |
| | 512 | 482,836 | 48 MB | 2 |

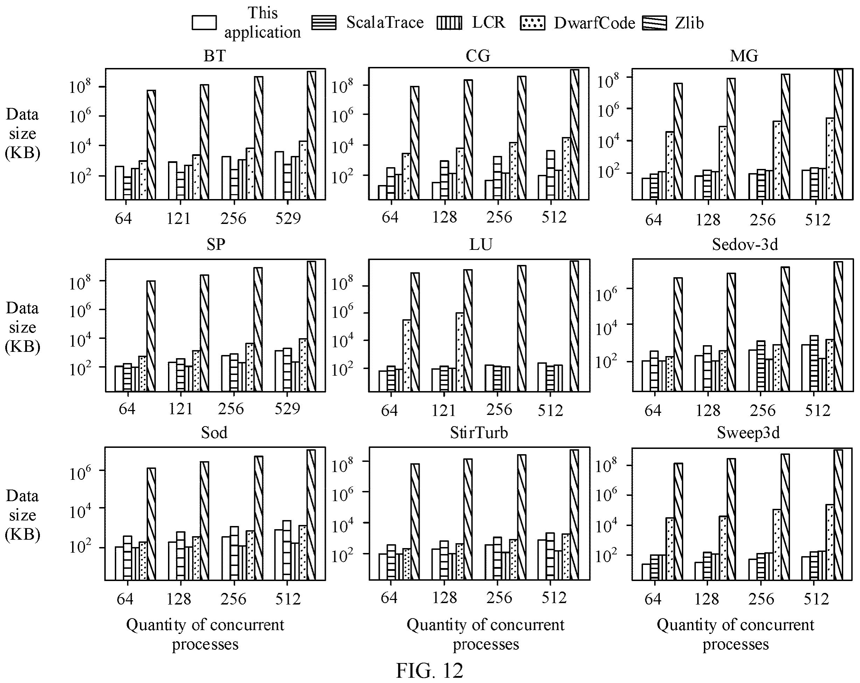

Further, for the trace logs generated in the running processes of the test programs and the performance data (which are referred to as data corresponding to Table 1 below) of the hardware resources occupied by the program processes that are shown in Table 1, FIG. 12 shows comparison results of compression rates of compressing data by using the method in embodiments of this application and other compression methods. The other compression methods include a ScalaTrace method, a DwarfCode method, an LCR method, and a general Zlib method. The ScalaTrace method, the DwarfCode method, and the LCR method are compression methods in cutting-edge paper research. Details are not described herein.

As shown in FIG. 12, a horizontal axis of the bar chart shown in FIG. 12 indicates different data compression methods, and a vertical axis indicates a data size obtained by compressing the data corresponding to Table 1. It can be learned that when the data corresponding to Table 1 is compressed by using the method in embodiments of this application, a compression rate is significantly better than that of Zlib. In addition, compared with the ScalaTrace method, the DwarfCode method, and the LCR method, the method provided in embodiments of this application are also advantageous.

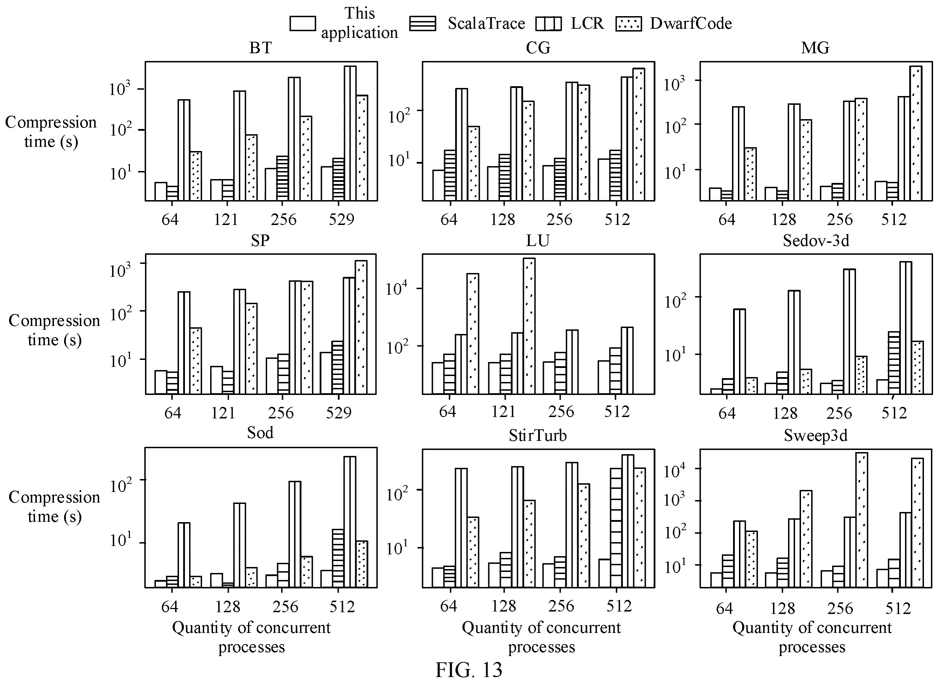

For the data corresponding to the table, FIG. 13 shows comparison results of compression time for compressing data by using the method in embodiments of this application and other compression methods. The other compression methods include a ScalaTrace method, a DwarfCode method, and an LCR method.

As shown in FIG. 13, a horizontal axis of the bar chart shown in FIG. 13 indicates different data compression methods, and a vertical axis indicates compression time consumed for compressing the data corresponding to Table 1. It can be learned that, compared with the ScalaTrace method, the DwarfCode method, and the LCR method, the method in embodiments of this application is much more advantageous in the compression time when being used to compress the data corresponding to Table 1.

With reference to the comparison result of the compression rate shown in FIG. 12 and the comparison result of the compression time shown in FIG. 13, the method in embodiments of this application is better than the other current compression methods.

In still another example, execution of 512 or 529 concurrent processes by the BT, LU, and SP of the NPB program is used as an example. Table 2 shows comparison of original sizes of trace logs and sizes of Zlib files that are generated during a single execution and sizes of files obtained by performing compression by using the method in embodiments of this application.

**Table 2**

| Test program | Original size of a trace log | Size of a Zlib file | Size of a file obtained by performing compression by using the method in embodiments of this application |
|---|---|---|---|
| BT | 24 GB | 880 MB | 3850 KB |
| LU | 183 GB | 4943 MB | 248 KB |
| SP | 41 GB | 1317 MB | 1531 KB |

It can be learned that a compression rate of the method in embodiments of this application is much higher than a compression result of the Zlib method.

In addition, a supercomputer system is used as an example. If the system scale is about 30,000 CPU cores, a log record requirement of about 100,000 cores of trace logs is generated every month on average, and storage overheads are about 2400 TB per year. Therefore, when the method in embodiments of this application is used to compress the trace log, storage and bandwidth overheads can be reduced by more than 99% compared with those of the Zlib compression method.

The foregoing mainly describes the solutions provided in embodiments of this application from a perspective of the method.

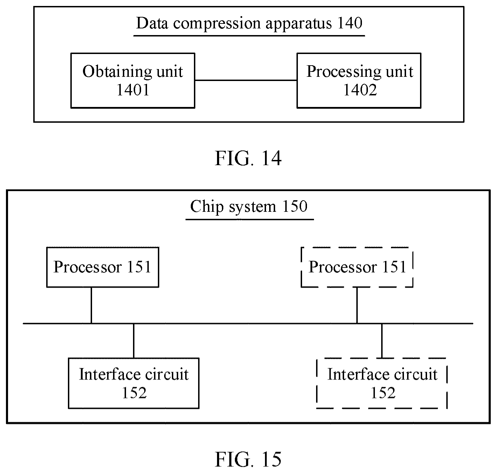

To implement the foregoing functions, FIG. 14 is a diagram of a structure of a data compression apparatus 140 according to an embodiment of this application. The data compression apparatus 140 may be configured to perform the foregoing data compression method, for example, configured to perform the data compression method shown in FIG. 5, FIG. 7, FIG. 9, or FIG. 10. The data compression apparatus 140 may include an obtaining unit 1401 and a processing unit 1402.

The obtaining unit 1401 is configured to obtain a first trace log generated in a running process of a first process, where the first trace log includes at least one log record, each log record in the first trace log includes a function call record of calling a communication function by the first process, and the communication function is a function for communication. The processing unit 1402 is configured to construct a first dictionary and a first grammar set based on the function call record in the first trace log, to compress the function call record in the first trace log, where the first dictionary includes at least one symbol string, and the first grammar set includes at least one grammar tree; and for a first function call record included in any log record in the first trace log, a first symbol string in the first dictionary indicates the first function call record, and a first grammar tree in the first grammar set indicates a function call relationship in the first function call record.

In an example, with reference to FIG. 5, the obtaining unit 1401 may be configured to perform S101, and the processing unit 1402 may be configured to perform S102.

Optionally, the communication function includes an MPI function.

Optionally, the first dictionary further includes a first description information set, the first description information set includes at least one piece of description information, and the at least one piece of description information includes description information used to describe semantics of each symbol string in the first dictionary. When function call records in at least two log records in the first trace log have a same semantic structure, symbol strings that are in the first dictionary and that indicate the function call records in the at least two log records correspond to one piece of description information in the first description information set.

Optionally, when the first process is a process of a target application, the target application further includes a second process, and a second dictionary including a second description information set is obtained when a function call record in a second trace log generated in a running process of the second process is compressed. The processing unit 1402 is further configured to: when it is determined that a quantity of pieces of different description information in the first description information set and the second description information set exceeds a threshold, compress the first description information set and the second description information set based on a text similarity between the different description information in the first description information set and the second description information set.

In an example, with reference to FIG. 9, the processing unit 1402 may be configured to perform S303.

Optionally, the processing unit 1402 is further configured to: when it is determined that the quantity of pieces of different description information in the first description information set and the second description information set is less than the threshold, combine the first description information set and the second description information set.

In an example, with reference to FIG. 9, the processing unit 1402 may be configured to perform S304.

Optionally, when the first process is a process of a target application, the target application further includes a second process, and a second grammar set is further obtained when a function call record in a second trace log generated in a running process of the second process is compressed. The processing unit 1402 is further configured to combine the first grammar set and the second grammar set based on function communication between the first process and the second process.

In an example, with reference to FIG. 9, the processing unit 1402 may be configured to perform S305.

Optionally, each log record in the first trace log further includes time data, and the time data includes start time of calling the communication function and calling duration. The processing unit 1402 is further configured to compress time data in the first trace log based on same calling duration in the first trace log.

In an example, with reference to FIG. 5, the processing unit 1402 may be configured to perform S103.

Optionally, when a hardware resource occupied by the first process in a node is a first hardware resource, the obtaining unit 1401 is further configured to obtain a first dataset, where the first dataset includes performance data of the first hardware resource at a plurality of moments in the running process of the first process. The processing unit 1402 is further configured to indicate, based on a preset value corresponding to each clustering range, data that is in the first dataset and that is within each clustering range, to obtain a second dataset obtained by compressing the first dataset.

In an example, with reference to FIG. 7, the obtaining unit 1401 may be configured to perform S201, and the processing unit 1402 may be configured to perform S202.

Optionally, the performance data includes at least one of the following: IPC, a CMR, a CHR, and a BMR.

Optionally, when the first process is a process of a target application, the target application further includes a second process, a hardware resource occupied by the second process in a node is a second hardware resource, a third dataset includes performance data of the second hardware resource at a plurality of moments in a running process of the second process, and a fourth dataset is obtained by compressing the third dataset based on the preset value corresponding to each clustering range. The processing unit 1402 is further configured to indicate, based on the preset value corresponding to each clustering range, data that is in the second dataset and the fourth dataset and that is within each clustering range, to compress the second dataset and the fourth dataset.

In an example, with reference to FIG. 10, the processing unit 1402 may be configured to perform S402.

Optionally, the first process and the second process run on different nodes.

For detailed descriptions of the foregoing optional manners, refer to the foregoing method embodiments. Details are not described herein again. In addition, for descriptions of any explanation and beneficial effect of the data compression apparatus 140 provided above, refer to the foregoing corresponding method embodiments. Details are not described again.

In an example, with reference to FIG. 4, a function implemented by the obtaining unit 1401 in the data compression apparatus 140 may be implemented by the communication interface 403 shown in FIG. 4, and a function implemented by the processing unit 1402 may be implemented by the processor 401 in FIG. 4 by executing the program code in the memory 402 in FIG. 4.

A person skilled in the art should be easily aware that, with reference to units and algorithm steps of the examples described in embodiments disclosed in this specification, this application can be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

It should be noted that, in this application, division into the modules in FIG. 14 is an example, is merely logical function division, and may be other division in an actual implementation. For example, at least two functions may be integrated into one processing module. The integrated module may be implemented in a form of hardware, or may be implemented in a form of a software functional module.

An embodiment of this application further provides a chip system 150. As shown in FIG. 15, the chip system 150 includes at least one processor and at least one interface circuit. In an example, when the chip system 150 includes one processor and one interface circuit, the processor may be a processor 151 shown in a solid line box (or a processor 151 shown in a dashed line box) in FIG. 15, and the interface circuit may be an interface circuit 152 shown in a solid line box (or an interface circuit 152 shown in a dashed line box) in FIG. 15. When the chip system 150 includes two processors and two interface circuits, the two processors include a processor 151 shown in a solid line box and a processor 151 shown in a dashed line box in FIG. 15, and the two interface circuits include an interface circuit 152 shown in a solid line box and an interface circuit 152 shown in a dashed line box in FIG. 15. This is not limited herein.

The processor 151 and the interface circuit 152 may be connected to each other through a line. For example, the interface circuit 152 may be configured to receive a signal (for example, obtain a trace log). For another example, the interface circuit 152 may be configured to send a signal to another apparatus (for example, the processor 151). For example, the interface circuit 152 may read instructions stored in a memory, and send the instructions to the processor 151. When the instructions are executed by the processor 151, the data compression apparatus may be enabled to perform the steps in the foregoing embodiments. Certainly, the chip system 150 may further include another discrete device. This is not specifically limited in this embodiment of this application.

An embodiment of this application further provides a computer program product and a computer-readable storage medium configured to store the computer program product. The computer program product may include one or more program instructions. When the one or more program instructions are run by one or more processors, the foregoing functions or some of the functions described with respect to FIG. 5, FIG. 7, FIG. 9, or FIG. 10 may be provided. Therefore, for example, one or more features in S101 to S103 in FIG. 5 may be implemented by using one or more instructions in the computer program product.

In some examples, the data compression apparatus described in FIG. 5, FIG. 7, FIG. 9, or FIG. 10 may be configured to provide various operations, functions, or actions in response to one or more program instructions stored in the computer-readable storage medium.

All or some of the foregoing embodiments may be implemented by software, hardware, firmware, or any combination thereof. When a software program is used to implement embodiments, embodiments may be implemented completely or partially in a form of a computer program product. The computer program product includes one or more computer instructions. When the computer-executable instructions are executed on a computer, the procedures or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (solid-state drive, SSD)), or the like.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A data compression method, comprising:
Obtaining a first trace log generated in a running process of a first process, wherein the first trace log comprises at least one log record, each log record in the first trace log comprises a function call record of calling a communication function by the first process, and the communication function is a function for communication; and
Constructing a first dictionary and a first grammar set based on the function call record in the first trace log, to compress the function call record in the first trace log, wherein the first dictionary comprises at least one symbol string, and the first grammar set comprises at least one grammar tree; and for a first function call record comprised in any log record in the first trace log, a first symbol string in the first dictionary indicates the first function call record, and a first grammar tree in the first grammar set indicates a function call relationship in the first function call record.

2. The method according to claim 1, wherein the communication function comprises a message passing interface MPI function.

3. The method according to claim 1 or 2, wherein the first dictionary further comprises a first description information set, the first description information set comprises at least one piece of description information, and the at least one piece of description information comprises description information used to describe semantics of each symbol string in the first dictionary; and
when function call records in at least two log records in the first trace log have a same semantic structure, symbol strings that are in the first dictionary and that indicate the function call records in the at least two log records correspond to one piece of description information in the first description information set.

4. The method according to claim 3, wherein when the first process is a process of a target application, the target application further comprises a second process, and a second dictionary is obtained when a function call record in a second trace log generated in a running process of the second process is compressed, and the second dictionary comprises a second description information set; and the method further comprises:
when it is determined that a quantity of pieces of different description information in the first description information set and the second description information set exceeds a threshold, compressing the first description information set and the second description information set based on a text similarity between the different description information in the first description information set and the second description information set.

5. The method according to claim 4, wherein the method further comprises:
when it is determined that the quantity of pieces of different description information in the first description information set and the second description information set is less than the threshold, combining the first description information set and the second description information set.

6. The method according to any one of claims 1 to 5, wherein when the first process is a process of a target application, the target application further comprises a second process, and a second grammar set is further obtained when a function call record in a second trace log generated in a running process of the second process is compressed; and the method further comprises:
combining the first grammar set and the second grammar set based on function communication between the first process and the second process.

7. The method according to any one of claims 4 to 6, wherein the first process and the second process run on different nodes.

8. The method according to any one of claims 1 to 7, wherein each log record in the first trace log further comprises time data, and the time data comprises start time of calling the communication function and calling duration; and the method further comprises:
compressing time data in the first trace log based on same calling duration in the first trace log.

9. The method according to any one of claims 1 to 8, wherein a hardware resource occupied by the first process in a node is a first hardware resource, and the method further comprises:
obtaining a first dataset, wherein the first dataset comprises performance data of the first hardware resource at a plurality of moments in the running process of the first process; and
indicating, based on a preset value corresponding to each clustering range, data that is in the first dataset and that is within each clustering range, to obtain a second dataset obtained by compressing the first dataset.

10. The method according to claim 9, wherein the performance data comprises at least one of the following:
instructions per cycle IPC, a cache miss rate CMR, a cache hit rate CHR, and a branch misprediction rate BMR.

11. The method according to claim 9 or 10, wherein when the first process is a process of a target application, the target application further comprises a second process, a hardware resource occupied by the second process in a node is a second hardware resource, a third dataset comprises performance data of the second hardware resource at a plurality of moments in a running process of the second process, and a fourth dataset is obtained by compressing the third dataset based on the preset value corresponding to each clustering range; and the method further comprises:
indicating, based on the preset value corresponding to each clustering range, data that is in the second dataset and the fourth dataset and that is within each clustering range, to compress the second dataset and the fourth dataset.

12. A data compression apparatus, comprising:
an obtaining unit, configured to obtain a first trace log generated in a running process of a first process, wherein the first trace log comprises at least one log record, each log record in the first trace log comprises a function call record of calling a communication function by the first process, and the communication function is a function for communication; and
a processing unit, configured to construct a first dictionary and a first grammar set based on the function call record in the first trace log, to compress the function call record in the first trace log, wherein the first dictionary comprises at least one symbol string, and the first grammar set comprises at least one grammar tree; and for a first function call record comprised in any log record in the first trace log, a first symbol string in the first dictionary indicates the first function call record, and a first grammar tree in the first grammar set indicates a function call relationship in the first function call record.

13. The apparatus according to claim 12, wherein the communication function comprises a message passing interface MPI function.

14. The apparatus according to claim 12 or 13, wherein the first dictionary further comprises a first description information set, the first description information set comprises at least one piece of description information, and the at least one piece of description information comprises description information used to describe semantics of each symbol string in the first dictionary; and
when function call records in at least two log records in the first trace log have a same semantic structure, symbol strings that are in the first dictionary and that indicate the function call records in the at least two log records correspond to one piece of description information in the first description information set.

15. The apparatus according to claim 14, wherein when the first process is a process of a target application, the target application further comprises a second process, a second dictionary is obtained when a function call record in a second trace log generated in a running process of the second process is compressed, and the second dictionary comprises a second description information set; and
the processing unit is further configured to: when it is determined that a quantity of pieces of different description information in the first description information set and the second description information set exceeds a threshold, compress the first description information set and the second description information set based on a text similarity between the different description information in the first description information set and the second description information set.

16. The apparatus according to claim 15, wherein
the processing unit is further configured to: when it is determined that the quantity of pieces of different description information in the first description information set and the second description information set is less than the threshold, combine the first description information set and the second description information set.

17. The apparatus according to any one of claims 12 to 16, wherein when the first process is a process of a target application, the target application further comprises a second process, and a second grammar set is further obtained when a function call record in a second trace log generated in a running process of the second process is compressed; and
the processing unit is further configured to combine the first grammar set and the second grammar set based on function communication between the first process and the second process.

18. The apparatus according to any one of claims 15 to 17, wherein the first process and the second process run on different nodes.

19. The apparatus according to any one of claims 12 to 18, wherein each log record in the first trace log further comprises time data, and the time data comprises start time of calling the communication function and calling duration; and
the processing unit is further configured to compress time data in the first trace log based on same calling duration in the first trace log.

20. The apparatus according to any one of claims 12 to 19, wherein a hardware resource occupied by the first process in a node is a first hardware resource;
the obtaining unit is further configured to obtain a first dataset, wherein the first dataset comprises performance data of the first hardware resource at a plurality of moments in the running process of the first process; and
the processing unit is further configured to indicate, based on a preset value corresponding to each clustering range, data that is in the first dataset and that is within each clustering range, to obtain a second dataset obtained by compressing the first dataset.

21. The apparatus according to claim 20, wherein the performance data comprises at least one of the following:
instructions per cycle IPC, a cache miss rate CMR, a cache hit rate CHR, and a branch misprediction rate BMR.

22. The apparatus according to claim 20 or 21, wherein when the first process is a process of a target application, the target application further comprises a second process, a hardware resource occupied by the second process in a node is a second hardware resource, a third dataset comprises performance data of the second hardware resource at a plurality of moments in a running process of the second process, and a fourth dataset is obtained by compressing the third dataset based on the preset value corresponding to each clustering range; and
the processing unit is further configured to indicate, based on the preset value corresponding to each clustering range, data that is in the second dataset and the fourth dataset and that is within each clustering range, to compress the second dataset and the fourth dataset.

23. A data compression apparatus, comprising: a memory, a communication interface, and one or more processors, wherein the one or more processors receive or send data through the communication interface, and the one or more processors are configured to read program instructions stored in the memory, to perform the method according to any one of claims 1 to 11.

24. A computer-readable storage medium, wherein the computer-readable storage medium comprises program instructions, and when the program instructions are run on a computer or a processor, the computer or the processor is enabled to perform the method according to any one of claims 1 to 11.
